# EUROPÄISCHE PATENTANMELDUNG

(11) **EP 0 585 848 A1**
(43) Veröffentlichungstag der Anmeldung: **09.03.1994**
(21) Anmeldenummer: 93113803.6
(22) Anmeldetag: 30.08.1993
(51) Int. Cl.: C23C 16/44, C23C 16/40

(54) **Verfahren und Vorrichtung zur chemischen Gasphasenabscheidung dünner Schichten**

(30) Priorität: 02.09.1992 DE 4229247
(71) Anmelder: HOECHST AKTIENGESELLSCHAFT, D-65929 Frankfurt am Main (DE)
(72) Erfinder: Häussler, Peter Dr., D-76227 Karlsruhe (DE); Steinig, Heinz, D-65529 Waldems (DE)

(57) **Zusammenfassung**

Ein Verfahren zur chemischen Gasphasenabscheidung (CVD) dünner Schichten mit Hilfe von Precursoren umfaßt die Herstellunf einer Precursorenlegierung aus wenigstens zwei Einzelkomponenten mit homogener chemischer Zusammensetzung, die Dosierung der Precursorenlegierung und danach die unmittelbare vollständige Verdampfung. Die Erfindung betrifft auch eine Vorrichtung zur Durchführung des CVD-Verfahrens umfassend einen geschlossenen Verdampfer **(14)**, dem eine Dosiervorrichtung **(20)** mit Förderschnecke **(22)** vorgeschaltet ist, einen Verdampfungsraum **(25)**,einen Kamin **(28)** und eine beheizbare Substrathalterung **(30)**.

## Beschreibung

Die vorliegende Erfindung betrifft ein Verfahren zur chemischen Gasphasenabscheidung dünner Schichten unter Einsatz von Precursoren sowie eine Vorrichtung zur Durchführung des Verfahrens.

Legierungsschichten aus verschiedenen Metallen, gegebenenfalls in Form von Verbindungen mit Sauerstoff oder Stickstoff, werden in großem Umfang in der Technik als Schutzschichten oder Funktionsschichten eingesetzt. Funktionsschichten können zum Beispiel auch Schichten aus hochtemperatursupraleitenden oxidischen Materialien sein .

In Anwesenheit von Sauerstoff können solche Schichten durch thermisches Verdampfen der elementaren Metalle, durch Sputterverfahren, Laserablation oder der Metal Organic Chemical Vapor Deposition (MO-CVD-Methode) hergestellt werden. Die letztgenannte Methode setzt im wesentlichen β-Diketonate ein, um einen metallorganischen Dampf zu erzeugen. Sie besitzt eine Reihe wichtiger, für bestimmte Anwendungen unverzichtbarer Vorteile. Die Abscheiderate kann sehr hoch sein, insbesondere im Bereich von 2 bis 10 µm/s), Drähte und Fasern können von allen Seiten beschichtet werden, insbesondere auch von der Rückseite, die Temperatur der Verdampfung liegt wegen des hohen Dampfdruckes der metallorganischen Verbindungen in einem bequem beherrschbaren Bereich zwischen 100 und 250 °C und die Metallatome sind während der Verdampfung bis zur Bildung der Schicht durch die Verkopplung mit den organischen Liganden vor unerwünschten und störenden Nebenreaktionen wirksam geschützt. Der Schutz vor Nebenreaktionen ist insbesondere wichtig, wenn sauerstoffreaktive Elemente wie Barium, Yttrium, Kalzium, Strontium oder auch Kupfer in Anwesenheit von Sauerstoff abgeschieden werden sollen.

Bei den üblichen CVD-Auftragsverfahren wird pro metallischer Einzelkomponente in der Gesamtmischung jeweils ein gesonderter Verdampfer eingesetzt, der mit dem Material dieser Einzelkomponente gefüllt wird. Jeder der Verdampfer muß allerdings auf 0,1 K genau auf eine bestimmte Temperatur eingestellt und bei dieser Temperatur gehalten werden, damit Schwankungen in der chemischen Zusammensetzung der erzeugten Schicht nicht auftreten, die unter allen Umständen vermieden werden müssen. Zusätzlich muß noch für jeden Verdampfer ein Trägergas mit einer bestimmten gleichmäßigen Strömungsgeschwindigkeit bereitgestellt werden, wobei jedwede Schwankung der Strömungsgeschwindigkeiten der einzelnen Trägergase relativ zueinander strengstens zu vermeiden ist, weil dadurch ebenfalls wieder Ungenauigkeiten bezüglich der chemischen Zusammensetzung der Schichten hervorgerufen werden.

Selbst wenn sowohl die Temperatur der Verdampfer als auch die Strömungsgeschwindigkeiten der Trägergase hinlänglich konstant gehalten werden, führt die intrinsische Instabilität der Erdalkalimetallprecursoren zu beträchtlichen technischen Problemen. In dem Temperaturbereich oberhalb von 220 °C, in dem eine nennenswerte Verdampfungsrate für Ba(thd)₂ beobachtet wird, ändert sich die Verdampfungsrate selbst bei gleichbleibender Temperatur kontinuierlich auch noch nach vielen Stunden oder sogar Tagen. An einen Langzeitbeschichtungsprozeß ist unter diesen Umständen nicht zu denken.

Die WO 91/07236 beschreibt ein MO-CVD-Verfahren, bei dem eine Mischung von verschiedenen metallorganischen Verbindungen (Precursormischung) mit voreingestellter Zusammensetzung verdampft wird, und eine Vorrichtung hierfür. Bei diesem Verfahren wird der Transport des pulverförmigen Materials mit Hilfe von Argon, das unter einem hohen Druck steht, als Trägergas bewirkt. Bei dem beschriebenen Verfahren läßt es sich aber nicht zuverlässig vermeiden, daß unbeabsichtigterweise Precursorenmaterial bis zum Substrat gespritzt wird, ohne vorher in die Gasphase überzugehen. Direkte Spritzer führen aber zu unerwünschten Konzentrationsschwankungen auf dem Substrat. Ferner ist die Aufwachsrate solcher Schichten sehr hoch, was negative Auswirkungen auf die Kristallqualität der Schichten hat.

Alle bekannten CVD-Verfahren haben den Nachteil, daß sie nach einer individuell begrenzten Laufzeit abgebrochen und neu eingestellt oder während des Verfahrensablaufes nachreguliert werden müssen. Eine kontinuierliche Verfahrensführung ist nicht möglich oder so störanfällig, daß nur minderwertige, weil in der Qualität schwankende Erzeugnisse daraus resultieren. Eine hinlänglich genaue Ratenregelung für den MO-CVD Prozeß ist bislang nicht bekannt.

Aufgabe der vorliegenden Erfindung war es daher, ein Verfahren zur chemischen Gasphasenabscheidung von Gemischen anzugeben, das eine vereinfachte Verfahrensführung ermöglicht und das vor allen Dingen kontinuierlich mit hoher Abscheidungsrate betrieben werden kann.

Gelöst wird diese Aufgabe durch ein Verfahren zur chemischen Gasphasenabscheidung dünner Schichten unter Einsatz von Precursoren, dessen Kennzeichenmerkmale darin zu sehen sind, daß eine Precursorenlegierung aus wenigstens zwei Einzelkomponenten mit homogener chemischer Zusammensetzung hergestellt wird, daß die Precursorenlegierung dann dosiert wird und daß die dosierte Precursorenlegierung dann unmittelbar vollständig verdampft wird.

Die vollständige Verdampfung der dosierten Precursorenlegierung geschieht vorzugsweise bei Temperaturen oberhalb 40 K über der Verdampfungstemperatur der bei der höchsten Temperatur verdampfenden Einzelkomponente der Precursorenlegierung.

Unter einer Precursorenlegierung wird im Rahmen der vorliegenden Erfindung ein homogenes Material verstanden, das durch Herstellen einer Mischung der pulverförmigen Einzelkomponenten, Homogenisieren der Mischung und, bei Feststofflösungen, durch ein anschließendes Reaktionssintern erhalten wird.

Die Precursorenlegierung kann sowohl eine Feststofflösung in Form eines rieselfähigen Pulvers sein als auch eine Lösung oder fließfähige Dispersion in einem geeigneten Löse- oder Dispersionsmittel. Das Löse- oder Dispersionsmittel verflüchtigt sich normalerweise bei den für die spätere Verdampfung notwendigen hohen Temperaturen.

Die chemische Zusammensetzung der Precursorenlegierung wird zweckmäßigerweise entsprechend den später beabsichtigten Anteilen der Einzelkomponenten innerhalb der Schicht, die durch das erfindungsgemäße Verfahren aufgetragen werden soll, voreingestellt. Dabei ist eine auf jeden Einzelbestandteil bezogene Schwundquote, die gegebenenfalls bei der Zersetzung der Precursoren an dem beheizten Substrat oder der individuellen Depositionsrate auftritt, mitzuberücksichtigen.

Die Dosierung der Precursorenlegierung geschieht insbesondere kontinuierlich und hat zum Ziel, daß ein kontinuierlicher Strom oder kleine Einheiten sequentiell in den Verdampfer eingebracht werden können und dort unmittelbar und vollständig verdampfen. Die vollständige Verdampfung ist im Rahmen der vorliegenden Erfindung besonders bedeutsam, weil damit die Konstanz der chemischen Zusammensetzung der abgeschiedenen Schicht gewährleistet wird. Um die dosierte Precursorenlegierung wirklich vollständig zu verdampfen arbeitet das erfindungsgemäße Verfahren bei Temperaturen von vorzugsweise oberhalb 50 K über der Verdampfungstemperatur der bei der höchsten Temperatur verdampfenden Einzelkomponente.

Bei dem erfindungsgemäßen Verfahren haben Temperaturschwankungen während der Verdampfung keine so unmittelbar negativen Auswirkungen auf die Qualität der aufgetragenen Schichten zur Folge, wie dies bei einer Verfahrensführung mit mehreren parallel zueinander betriebenen Verdampfern der Fall ist. Die kontinuierliche Dosierung ermöglicht weiterhin eine Langzeitbeschichtung von Substraten, was mit bisherigen Methoden nicht möglich war.

Die Erfindung soll für den Fall einer Feststofflegierung der Precursoren anhand der beigefügten Zeichnungen beispielhaft noch näher erläutert werden, ohne aber auf die konkret dargestellten Ausführungsformen beschränkt zu sein.

Figur 1 zeigt schematisch einen Verfahrensablauf entsprechend der vorliegenden Erfindung.

Figur 2 zeigt eine schematische Darstellung eines Verdampfers, mit dem das erfindungsgemäße Verfahren durchgeführt werden kann.

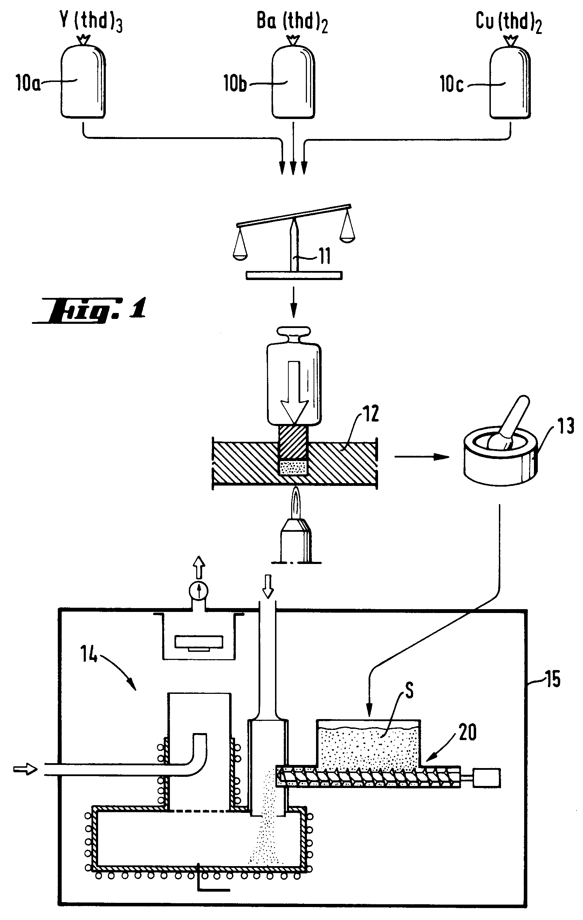

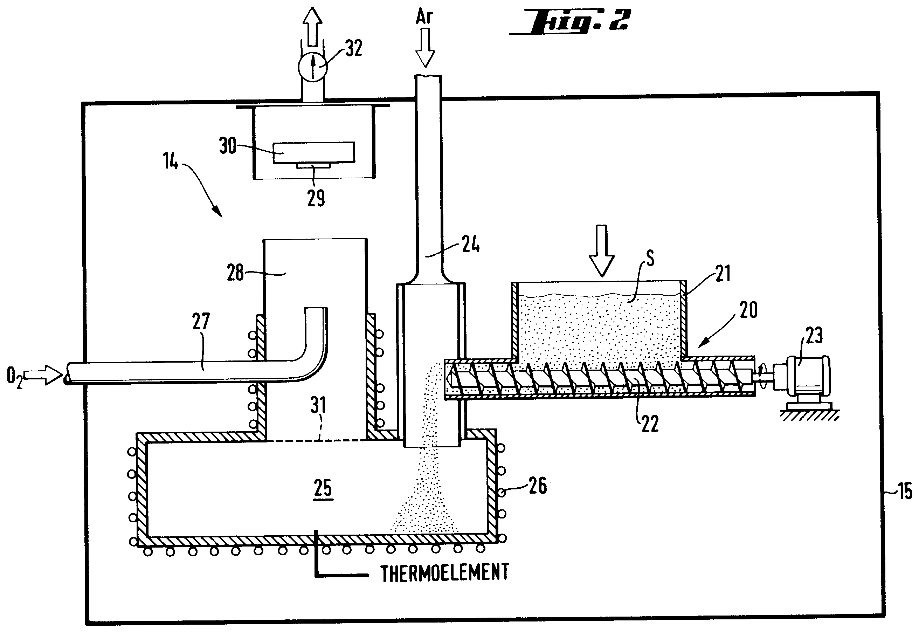

Die Figur 1 zeigt, daß in diesem Beispiel die Metalle Yttrium, Barium und Kupfer, die jeweils als entsprechende Tetramethylheptandionate vorgelegt werden, zunächt aus Vorratsbehältern 10a, 10b und 10c entnommen und in einer Vordosierstufe 11 gewogen und aufeinander abgestimmt werden. Dann wird die Mischung in einem Sinterschritt 12 homogenisiert und anschließend in einer Zerkleinerungsstation 13 in rieselfähigen Zustand versetzt. Die rieselfähige Precursorenlegierung wird sodann in einen Verdampfer 14 eingebracht, der für einen kontinuierlichen Betrieb geeignet ist und dessen nähere Einzelheiten sich aus Figur 2 ergeben.

Figur 2 zeigt einen Verdampfer 14 in einem geschlossenen Recipienten 15, dem eine Dosiervorrichtung 20 vorgeschaltet ist. Die Dosietvorrichtung 20 umfaßt in der Darstellung einen Vorratsbehälter 21 zur Aufnahme der Precursorenlegierung S der mit einer Förderschnecke 22 in Verbindung steht. Die Förderschnecke 22 wird zweckmäßigerweise von einem Motor 23 angetrieben. Mit Hilfe der Förderschnecke 22 gelangt die Precursorenlegierung S vorbei an dem Gaseinlaß 24 in den Verdampfungsraum 25, der allseitig von der Heizung 26 umgeben ist, und verdampft dort vollständig. Das durch den Gaseinlaß 24 eintretende Inertgas übernimmt im wesentlichen die Aufgabe, den Ort des Eintritts der Precursorenmischung in den geschlossenen Verdampfer 14 kühl zu halten. Durch das engmaschige Abschirmnetz 31, mit dem Materialspritzer von dem Substrat 29 ferngehalten werden, gelangt die dampfförmige Precursorenlegierung in den Kamin 28, wird dort über die Sauerstoffzuleitung 27 mit Sauerstoff angereichert und schlägt sich dann auf dem Substrat 29 nieder, das an einer beheizbaren Substrathalterung 30 entlanggeführt wird. Über die Pumpe 32 kann der gesamte Verdampfer 14 unter Vakuum gehalten werden.

## Patentansprüche

1. Verfahren zur chemischen Gasphasenabscheidung dünner Schichten unter Einsatz von Precursoren, dadurch gekennzeichnet, daß eine Precursorenlegierung aus wenigstens zwei Einzelkomponenten mit homogener chemischer Zusammensetzung hergestellt wird, daß die Precursorenlegierung dann dosiert wird und daß die dosierte Precursorenlegierung dann unmittelbar vollständig verdampft wird.

2. Verfahren nach Anspruch 1, dadurch gekennzeichnet, daß die dosierte Precursorenlegierung bei Temperaturen oberhalb 40 K über der Verdampfungstemperatur der bei der höchsten Temperatur verdampfenden Einzelkomponente vollständig verdampft wird.

3. Verfahren nach Anspruch 1, dadurch gekennzeichnet, daß als rieselfähige Precursorenlegierung eine Feststoffmischung in Form eines rieselfähigen Pulvers eingesetzt wird.

4. Verfahren nach Anspruch 1, dadurch gekennzeichnet, daß als fließfähige Precursorenlegierung eine Lösung oder Dispersion der Precursorenlegierung in einem geeigneten Löse- oder Dispersionsmittel eingesetzt wird.

5. Verfahren nach Anspruch 1, dadurch gekennzeichnet, daß die chemische Zusammensetzung der Precursorenlegierung entsprechend der Zusammensetzung der Einzelkomponenten in der aufzutragenden Schicht voreingestellt wird.

6. Verfahren nach Anspruch 1, dadurch gekennzeichnet, daß die Dosierung der Precursorenlegierung kontinuierlich durchgeführt wird.

7. Verfahren nach Anspruch 1, dadurch gekennzeichnet, daß die dosierte Precursorenlegierung bei Temperaturen von oberhalb 50 K über der Verdampfungstemperatur der bei der höchsten Temperatur verdampfenden Einzelkomponente vollständig verdampft wird.

8. Vorrichtung zur Durchführung des Verfahrens nach einem der Ansprüche 1 bis 7 umfassend einen geschlossenen Verdampfer (14), dem eine Dosierungsvorrichtung (20) mit Förderschnecke (22) vorgeschaltet ist, einen Verdampfungsraum (25), einen Kamin (28) und eine beheizbare Substrathalterung (30).

9. Vorrichtung nach Anspruch 8, dadurch gekennzeichnet, daß ein engmaschiges Abschirmnetz (31) den Verdampfungsraum (25) von dem Kamin (28) abtrennt.
